# EUROPEAN PATENT SPECIFICATION

(11) **EP 2 706 368 B1**
(45) Date of publication and mention of the grant of the patent: **07.11.2018**
(21) Application number: 13182726.3
(22) Date of filing: 03.09.2013
(51) Int. Cl.: G01R 31/34

(54) **Method for the detection of shorted turns on salient poles of rotors of electric rotating machines**
Verfahren zur Erkennung kurzgeschlossener Wicklungen auf Schenkelpolen von Rotoren elektrischer Drehmaschinen
Procédé de détection des court-circuits de pôles saillants de rotors de machines électriques tournantes

(30) Priority: 11.09.2012 US 201261699327 P
(43) Date of publication of application: 12.03.2014
(73) Proprietor: Vibrosystm Inc., Longueuil, Québec J4N 1L7 (CA)
(72) Inventor: Cloutier, Marius, Longueuil, Québec QC J4N 1L7 (CA)
(74) Representative: Bergenstråhle Group AB

(56) References cited:
- US-A1- 2008 136 360
- S R Campbell ET AL: "On-line Hydrogenerator Rotor Winding Condition Assessment Using Flux Monitoring", Waterpower XIV, 1 January 2005 (2005-01-01), pages 1-5, XP055402428, Retrieved from the Internet: URL:https://www.google.de/url?sa=t&rct=j&q =&esrc=s&source=web&cd=18&ved=0ahUKEwi2zr3 u9v7VAhXEaVAKHU0wCMM4ChAWCEAwBw&url=http:/ /citeseerx.ist.psu.edu/viewdoc/download?do i=10.1.1.518.9263&rep=rep1&type=pdf&usg=AF QjCNHbENPjyPDncknYl8YfwE5gbpRnzA [retrieved on 2017-08-30]

## Description

### TECHNICAL FIELD

The present invention relates to a method to detect short-circuits in the electrical windings of rotor poles of rotating machines in the case where such poles are salient.

### BACKGROUND OF THE ART

On electrical machines such as hydro-generators, the rotor poles are salient and the electrical windings are constituted by insulated strips of copper surrounding the pole so that each copper turn is isolated from the adjacent ones and from the rotor pole.

After years of operation, insulation aging will occur and may cause shorts in some turns, a condition which may degrade the performance of the machine.

To detect such shorted turns, two main methods are known:

The first method is known in the trade as the "Pole Drop" test and is practiced at a shutdown of the machine. The machine is opened and an AC voltage across each pole is measured. Shorted turns are detected by the smaller than average voltage drop across a pole. The biggest disadvantages of this method are that the machine has to be stopped, the tests may have to be conducted for a long period of time, and shorts that may be happening when the machine is rotating may not be detected when no rotation occurs because they are due to centrifugal force that does not act at machine standstill.

The second method is known as "Flux Monitoring". A flat coil is glued to the stator and measures the radial magnetic flux emitted in the air-gap by each rotating pole. The voltage generated in the coil is proportional to the radial flux emitted by each pole, so that if there is a shorted turn in a pole, at a given load, an abnormal change in the flux profile of such pole in comparison to the other poles is believed to become apparent.

This method has the advantage of being an on-line tool that does not need the machine to be stopped and opened. However, although this method has been successfully used for many years for cylindrical rotors having non-salient poles, it has only been recently introduced for salient pole machines, and there have been instances where shorted turns that were not detected by such method have nevertheless been uncovered by Pole Drop tests.

The reasons why this Flux Monitoring method does not seem as satisfying with salient rotor poles as it is with non-salient rotor poles are not clear, the most common being that "interpretation of the flux patterns " of a salient pole "is not obvious" (S.R. Campbell et al. - Waterpower XIV - HCI Publications, 2005), probably due to the fact that salient pole machines have all their turns on one pole superimposed instead of being distributed along the pole as they are in the case of non-salient pole machines.) This creates a constant overlapping of the flux patterns created by the neighboring turns on the flux pattern of a defective pole so that the signature of that defective pole becomes undistinguishable from that of the neighboring ones.

Even more, the relationship between the Flux density and the Ampere-turns is not linear as shall be seen later. That non-linearity may dampen the effect of a small number of shorted turns so much so that it may become impossible to detect them when the machine operates on load in its standard use in the power grid.

Moreover, numerous observations and unsuccessful experiments have also led to believe that when a given hydro-generator is under load, and connected to a large grid that is fed by numerous other generators, there seems to be a "grid effect" that partly or totally dampens any short turn anomaly and seems to compensate for such deficiency.

One factor may be even more important than the ones cited above: the variation of the thickness of the air-gap between the poles and the stator in front of each pole of such salient pole machine may affect the resulting radial flux intensity from a pole more significantly than one or two shorted turns on such a pole.

Therefore, there is still a need for a method to detect shorted turns in salient rotor pole machines that is simple, not time-consuming and does not need a machine to be shut down and opened.

### SUMMARY

The present invention includes a two-step method to detect shorted turns in salient-pole rotors.

In a first step, it uses a coil to measure in real time the radial magnetic flux leaking in the air-gap of an operating electric rotating machine having salient rotor poles and also uses an air-gap sensor to measure the rotor-stator distance in real time as well, and calculates the influence of the air-gap thickness existing in front of each pole, so that major shorted turns are detected under normal working conditions of the machine.

In a second and optional step, in situations where shorted turns cannot be clearly diagnosed under the first step, the machine is taken off line, short-circuited and the magnetizing current applied to the rotor windings is totally cut off so that the magnetic flux is back to zero or almost zero; the magnetizing current is then gradually brought up to nominal capacity by gradual increases, while the radial flux is measured at each magnetizing current increasing fraction and the air-gap correction of the first step is applied to the measured radial flux.

With this second step, gradual magnetization of the rotor pole from a state where the magnetic remanence has a minimal or zero value, offers the maximum sensitivity in radial flux increases (ΔØ/ΔNI) in response to increases of the magnetizing current NI in the rotor windings, thus enabling to detect shorted turns at the maximum sensitivity level, for example with maximum accuracy.

Most shorted turns can be detected while the machine is operating, and for the remaining minor cases, it does not need any shut-down or any opening of the machine. The machine only needs to be taken off-line, to cut off the magnetizing current for a few seconds to let the magnetic flux return toward zero and to proceed with applying the first step of the method as the magnetizing current is gradually increased.

In accordance with a first broad aspect, there is provided a method for detecting shorted turns in the windings of salient rotor poles of an electric rotating machine, the method comprising: for each one of the salient rotor poles, measuring a radial magnetic flux between a stator of the electric rotating machine and the salient rotor pole, and measuring a thickness of an air-gap between the stator and the salient rotor pole; for each one of the salient rotor poles, determining an expected radial flux using the measured radial magnetic flux and the measured thickness of the air-gap; and identifying shorted turns by comparing, for each one of the salient rotor poles, the measured radial magnetic flux to the expected radial magnetic flux.

In one embodiment, the method further comprises, for each one of the salient rotor poles, determining a maximum radial magnetic flux from the measured radial flux, and a minimum air-gap thickness from the measured thickness of the air-gap.

In one embodiment, the step of determining the expected radial flux comprises: calculating an average value for the minimum air-gap thicknesses and an average value for the maximum radial magnetic fluxes; and for each one of the salient rotor poles, calculating the expected radial magnetic flux using the respective measured thickness of the air-gap, the average value for the minimum air-gap thicknesses and the average value for the maximum radial magnetic fluxes.

In one embodiment, the shorted turns are determined when a measured radial magnetic flux for a given salient rotor pole is less than the respective expected radial magnetic flux for the given salient rotor pole.

In one embodiment, the steps of measuring the radial magnetic flux and measuring the thickness of the air-gap are performed during at least one rotation of the electric rotating machine.

In one embodiment, the steps of measuring the radial magnetic flux and measuring the thickness of the air-gap are performed substantially continuously during the at least one rotation of the electric rotating machine.

In another embodiment, the steps of measuring the radial magnetic flux and measuring the thickness of the air-gap are performed in a stepwise manner during the at least one rotation of the electric rotating machine.

In one embodiment, the steps of measuring the radial magnetic flux and measuring the thickness of the air-gap are performed substantially concurrently using a magnetic radial flux sensor integrated with an air-gap sensor positioned in the air-gap.

In one embodiment, the method further comprises: bringing the electric rotating machine off-line; bringing a magnetic remanence of the salient rotor poles substantially near zero by shutting off a current flowing through the windings of the salient rotor poles; reinstating said current up to a nominal value; for each one of the salient rotor poles, measuring the radial magnetic flux and the thickness of the air-gap; for each one of the salient rotor poles, determining an expected radial flux using the measured radial magnetic flux and the measured thickness of the air-gap; and identifying shorted turns by identifying at least a given one of the salient rotor poles having a measured radial magnetic flux inferior to the corresponding expected radial magnetic flux.

In one embodiment, the method further comprises outputting an identification of a given one of the salient rotor poles for which shorted turns have been detected.

In accordance with another broad aspect, there is provided a system for detecting shorted turns in windings of salient rotor poles of an electric rotating machine comprising: a radial magnetic flux sensor for measuring a radial magnetic flux between the stator and the salient rotor pole, for each one of the salient rotor poles; an air-gap thickness sensor for measuring a thickness of an air-gap between the stator and the salient rotor pole, for each one of the salient rotor poles; and a calculation unit in communication with the magnetic radial flux sensor and the air-gap thickness sensor, the calculation unit for: for each one of the salient rotor poles, determining an expected radial flux using the measured radial magnetic flux and the measured thickness of the air-gap; and identifying shorted turns by comparing, for each one of the salient rotor poles, the measured radial magnetic flux to the expected radial magnetic flux.

In one embodiment, the radial magnetic flux sensor comprises a coil adapted to be positioned in the air-gap of the electric rotating machine.

In one embodiment, the radial magnetic flux sensor is integrated with the air-gap sensor.

In one embodiment, the calculation unit is further adapted to, for each one of the salient rotor poles, determine a maximum radial magnetic flux from the measured radial flux, and a minimum air-gap thickness from the measured thickness of the air-gap.

In one embodiment, the calculation unit is further adapted to: calculate an average value for the minimum air-gap thicknesses and an average value for the maximum radial magnetic fluxes; and for each one of the salient rotor poles, calculate the expected radial magnetic flux using the respective measured thickness of the air-gap, the average value for the minimum air-gap thicknesses and the average value for the maximum radial magnetic fluxes.

In one embodiment, the calculation unit is further adapted to identify the shorted turn when a measured radial magnetic flux for a given salient rotor pole is less than the respective expected radial magnetic flux for the given salient rotor pole.

In one embodiment, the radial magnetic flux sensor and the air-gap sensor are adapted to measure the radial magnetic flux and the thickness of the air-gap, respectively, during at least one rotation of the electric rotating machine.

In one embodiment, the system further comprises a control unit for: bringing the electric rotating machine off-line; bringing a magnetic remanence of the salient rotor poles substantially near zero by shutting off a current flowing through the windings of the salient rotor poles; and reinstating the current up to a nominal value, the measurement of the radial magnetic flux and the thickness of the air-gap, the determination of the expected radial flux, and the identification of the shorted turns being performed after the reinstatement of the current.

In one embodiment, the calculation unit is further adapted to output an identification of a given one of the salient rotor poles for which shorted turns have been detected.

In accordance with a further broad aspect, there is provided a computer program product comprising a computer readable memory for storing computer executable instructions thereon for detecting shorted turns in the windings of salient rotor poles of an electric rotating machine, the computer executable instructions for performing, upon execution by a computer, the steps of: receiving, for each one of the salient rotor poles, a measurement of a radial magnetic flux between a stator of the electric rotating machine and the salient rotor pole, and a measurement of a thickness of an air-gap between the stator and the salient rotor pole; for each one of the salient rotor poles, determining an expected radial flux using the measured radial magnetic flux and the measured thickness of the air-gap; and identifying shorted turns by comparing, for each one of the salient rotor poles, the measured radial magnetic flux to the expected radial magnetic flux.

In accordance with still a further broad aspect, there is provided a monitoring system for monitoring an air-gap thickness between a stator of a rotating machine and a rotor pole, and a magnetic flux between the stator and the rotor pole, the system comprising: an air-gap sensor for measuring the air-gap thickness and outputting a first electrical signal indicative of the air-gap thickness; a magnetic flux sensor for monitoring the magnetic flux and outputting a second electrical signal indicative of the magnetic flux, the second electrical signal having an electrical frequency lower than an electrical frequency of the first electrical signal; a triaxial cable having a first end connected to the air-gap sensor and to the magnetic flux sensor, and having a substantially low frequency bandwidth for transmitting the second electrical signal and a substantially high frequency bandwidth for transmitting the first electrical signal; a first capacitor operatively connected between the triaxial cable and the magnetic flux sensor; a first conditioner unit connected to a second end of the triaxial cable and adapted to receive the first electrical signal, extract the air-gap thickness form the first electrical signal, and output the air-gap thickness; and a second conditioner unit connected to a second end of the triaxial cable and adapted to receive the second electrical signal, extract a parameter indicative of the magnetic flux from the second electrical signal, and output the parameter; and a second capacitor operatively connected between the triaxial cable and the second conditioner unit.

In one embodiment, the monitoring system further comprises a coaxial cable operatively connected between the air-gap sensor and the triaxial cable.

In one embodiment, the magnetic flux sensor comprises a coil and is adapted to measure a voltage generated within the coil, the second electrical signal being indicative of the voltage and the second conditioner unit being adapted to extract the voltage from the second electrical signal.

In one embodiment, the second conditioner unit is further adapted to determine the magnetic flux between the stator and the rotor pole from the voltage, and output the magnetic flux.

### BRIEF DESCRIPTION OF THE DRAWINGS

FIG. 1 is a flow chart of a method for detecting shorted turns in the windings of salient rotor poles of an electric rotating machine, in accordance with an embodiment;
FIG. 2 is a graph illustrating simultaneous measurement of a radial magnetic flux and an air-gap thickness in an electric rotating machine having salient rotor poles;
FIG. 3 is a flow chart illustrating the calculation of an expected radial magnetic flux;
FIG. 4 illustrates an air-gap sensor, in accordance with an embodiment;
FIG. 5 illustrates an integrated sensor for measuring a radial magnetic flux and an air-gap thickness; and
FIG. 6 shows different zones of a hysteresis cycle in the ferro-magnetic core of a rotor pole.

### DETAILED DESCRIPTION

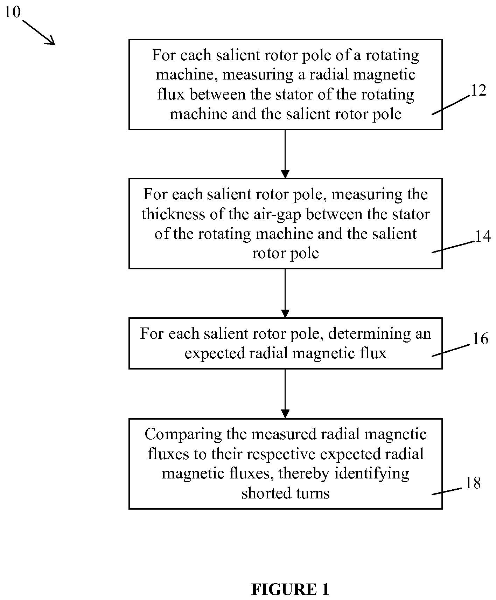

FIG. 1 illustrates one embodiment of a method 10 for detecting shorted turns in the windings of salient rotor poles of an electric rotating machine. At step 12, for each pole, the radial magnetic flux is measured using any adequate radial magnetic flux sensor such as a coil or a piezoelectric sensor. In the case of a coil sensor, it should be understood that the coil sensor monitors a voltage which is subsequently integrated in order to obtain the radial magnetic flux. At step 14, for each rotor pole, the air-gap thickness, i.e. the distance between the rotor pole and the stator, is measured using any adequate air-gap sensor adapted to be positioned between the rotor and the stator. At step 16, an expected radial flux is determined for each rotor pole using the above-described method. The expected radial flux for a given rotor pole is determined using the measured air gap distance and radial flux for the given rotor pole, and also the measured air-gap distance and radial flux for the other rotor poles, as described below. At step 18, for each rotor pole, the measured radial flux is compared to its respective expected radial flux. A shorted run is identified for each rotor pole for which the measured radial flux is less than its respective expected radial flux. Upon detection of a shorted turn, a signal is outputted. The signal may indicate that a shorted turn has been detected without specifying the given rotor pole for which the shorted turn has been detected. In another example, the signal may comprise an identification of each rotor pole for which a shorted turn has been detected. In a further example, the signal may be an alarm signal.

In one embodiment, the method 10 is performed while the machine operates, i.e. while the rotor is rotating. Therefore, there is no need to stop the operation of the machine.

In one embodiment, the magnetic radial flux and the air-gap thickness are substantially continuously monitored during one or more rotation of the rotor. In another embodiment, the magnetic radial flux and the air-gap thickness are monitored in a stepwise manner during one or more turns

This demonstrates the need to correct any measured value of the magnetic flux created by a given pole that is above or under the average flux of all poles, by taking into account whether the air-gap thickness in front of the pole is under or above the average air-gap of all poles.

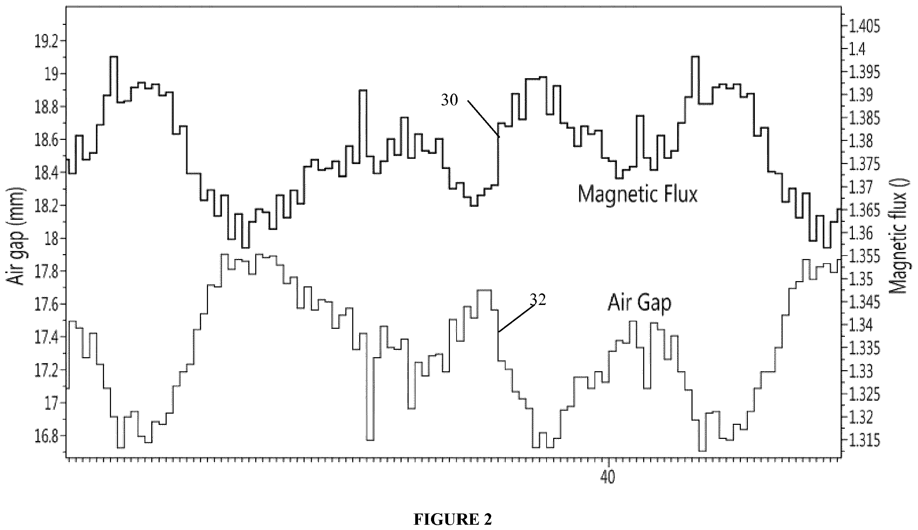

FIG. 2 shows the correlation, on a standard salient pole electric rotating machine, between the variation of magnetic flux 30 and the variation of the thickness of the air-gap 32 as measured by a flux sensor and an air-gap sensor. It clearly shows that the magnetic flux 30 increases as the air-gap thickness 32 diminishes and decreases as the air-gap thickness 32 increases. Thus, a shorted turn may exist on a given pole and not be detectable because the air-gap thickness 32 facing that pole is inferior to the average air-gap, while a shorted turn on a given pole may be falsely suspected because the air-gap thickness 32 facing that pole is above average.

Here is how the separation between the air-gap effect and the shorted turn effect on the magnetic field of a pole may be approximated so that only real shorted turns may be identified.

For a given machine, the following calculations are made:

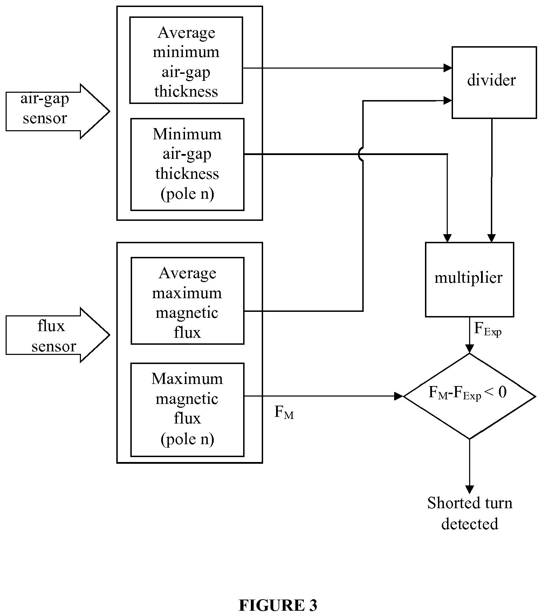

The air-gap thickness and the radial flux values are continuously measured. The minimum value of the air-gap thickness for each pole is calculated as well as the maximum (peak) value of radial flux for each pole over one complete rotation or turn of the rotor. Then, the average value of the minimum air-gap thickness and the average value of maximum radial flux are calculated. Once having these values, the expected maximum radial flux value for each pole is derived by the following Formula (1) which is illustrated in FIG. 3:

For Pole n, Expected Flux = Average Flux over one complete turn + (Average Air-Gap over one complete turn - Measured Air-Gap for Pole n) x (Average Flux over one complete turn / Average Air-Gap over one complete turn).

As illustrated in FIG. 3, if the calculated expected flux value for a given rotor pole is greater than the corresponding measured value, this will constitute the indication of one or more shorted turns for the given rotor pole.

Table 1 is an illustration of the above mentioned calculation method in the case of a rotor with 8 salient poles.

**Table 1. Example results for a rotor with 8 salient poles.**

| Pole # | P1 | P2 | P3 | P4 | P5 | P6 | P7 | P8 | Average |
|---|---|---|---|---|---|---|---|---|---|
| Air-Gap (mm) | 20 | 21 | 20 | 19 | 19 | 21 | 20 | 20 | 20 |
| Measured Flux (Tesla) | 0,95 | 0,95 | 1 | 1,05 | 1,05 | 0,95 | 1 | 1 | 0,994 |
| Calculated Flux (Tesla) | 0,99 | 0,94 | 0,99 | 1,04 | 1,04 | 0,94 | 0,99 | 0,99 | |
| Increase or Decrease of Measured over Calculated Flux (%) | -4% | 1% | 1% | 1% | 1% | 1% | 1% | 1% | |

Table 1 shows the measured values of air-gaps and radial fluxes in a given salient pole machine and their average values in rows 2 and 3. In the 4th row, fluxes are calculated according to Formula (1) and in the last row, the percentage of increase or decrease of the measured flux over the calculated flux for each pole is indicated.

Table 1 indicates that the only pole where the expected flux value is larger than the measured one is Pole 1, which shows the presence of at least one shorted turn on Pole 1. The more negative the percentage is, the more severe the shorted turn is.

In one embodiment, the method 10 is embodied as a system comprising a air-gap sensor for measuring the air-gap thickness, a magnetic flux sensor, and a calculation unit adapted to calculate the expected radial magnetic flux for each rotor pole and compare the measured radial magnetic flux to the corresponding expected radial magnetic flux, for each rotor pole, as described above.

In another embodiment, the method 10 is embodied as an apparatus comprising a processing unit, a memory or storing unit, and a communication unit for receiving the measurements of the air-gap sensor and the radial magnetic flux. The processing unit is configured for calculating the expected radial magnetic flux for each rotor pole and comparing the measured radial magnetic flux to the corresponding expected radial magnetic flux, for each rotor pole, as described above.

In a further embodiment, the method 10 is embodied as a computer program product comprising a computer readable memory for storing computer executable instructions thereon for detecting shorted turns in the windings of salient rotor poles of an electric rotating machine. Upon execution by a computer, the computer executable instructions perform the steps of: receiving, for each one of the salient rotor poles, a measurement of a radial magnetic flux between a stator of the electric rotating machine, and the salient rotor pole, and a measurement of a thickness of an air-gap between the stator and the salient rotor pole; for each one of the salient rotor poles, determining an expected radial flux using the measured radial magnetic flux and the measured thickness of the air-gap; and identifying shorted turns by comparing, for each one of the salient rotor poles, the measured radial magnetic flux to the expected radial magnetic flux.

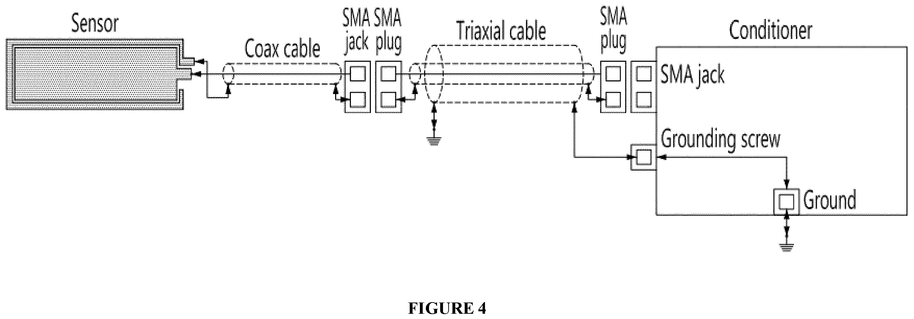

FIG. 4 illustrates one embodiment of a capacitive air-gap sensor with an integral coaxial cable, a triaxial extension cable and a conditioner. The capacitive air-gap sensor outputs an electrical signal indicative of the air-gap thickness between the stator and the rotor poles. The electrical signal propagates through the coaxial cable and the triaxial cable before reaching the conditioner. The conditioner comprises electrical circuitry adapted to extract the air-gap distance from the received electrical signal, and output the extracted air-gap thickness. The aim is to measure the rotor to stator distance in order to get the minimum value for each pole representing the air-gap.

In one embodiment, the triaxial cable is omitted so that the conditioner is directly connected to the coaxial cable for receiving the electrical signal outputted by the capacitive air-gap sensor. For example, such a configuration may be used when the conditioner is located at a substantially short distance from the capacitive air-gap sensor, and the capacitive air-gap sensor outputs a substantially low current electrical signal having a substantially high frequency.

In another embodiment, the coaxial cable is omitted so that the capacitive air-gap sensor is directly connected to the triaxial cable for transmitting the electrical current. For example, such a configuration may be used when the conditioner is located at a substantially great distance from the capacitive air-gap sensor, and the capacitive air-gap sensor outputs a substantially low current electrical signal having a substantially high frequency.

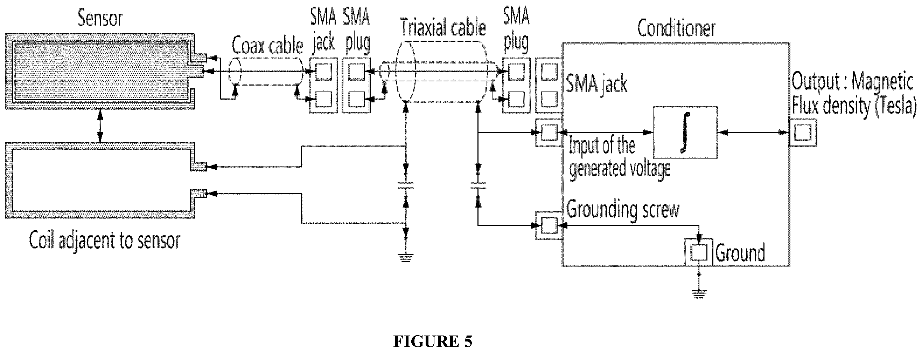

Another refinement and economic improvement of this method is illustrated in FIG. 5 and would consist in making sure that flux and air-gap measurements for each pole are taken simultaneously and in the same location. This can be achieved: a) by integrating the flat coil for flux measurement with the air-gap sensor of FIG. 4, and b) by using the air-gap electronic circuitry to generate and treat the flux data. This would necessitate only minor add-ons to the air-gap circuitry and also minimize the physical intrusions caused by the sensors by saving one cable and one dedicated electronic circuit, a feature that is not negligible in such a complex environment.

FIG. 5 illustrates a combined air gap and flux sensor. The combined sensor comprises the same elements as the sensor of FIG. 4, i.e. an air-gap sensor such as a capacitive air-gap sensor with an integral coaxial cable, a triaxial extension cable, and a conditioner. The combined sensor further comprises one capacitor at each end of the triaxial cable and a flux sensor such as a coil connected to the triaxial cable. The aim is to measure the rotor to stator distance in order to get the minimum value for each pole representing the air-gap and to get the peak flux value for each pole representing the radial magnetic flux. The measurements of the radial magnetic flux and the air-gap thickness signals are transmitted to the conditioner using the triaxial cable. This is achieved through the capacitors used as frequency signal splitters: the high frequency bandwidth of the triaxial cable is used for transmitting the air-gap thickness and the low frequency bandwidth is used transmitting the flux. Each capacitor has one end operatively connected to the triaxial cable and another end operatively connected to the ground. The capacitive air-gap sensor outputs a first electrical signal indicative of the air-gap thickness while the flux sensor outputs a second electrical signal indicative of the magnetic flux. The frequency of the first electrical signal is greater than that of the second electrical signal. The first electrical signal outputted by the capacitive air-gap sensor propagates first in the coaxial cable, and then in the triaxial cable before reaching the conditioner. The flux sensor is directly connected to the triaxial cable which is adapted propagates the first and second electrical signals up to the conditioner. The conditioner comprises electrical circuitry for extracting the air-gap thickness value from the first electrical signal, and the magnetic flux sensor from the second electrical signal. The conditioner is further adapted to output the determined air-gap thickness and flux values.

In one embodiment, the flux sensor comprises a coil and is adapted to measure a voltage generated within the coil, and the conditioner is adapted to extract the voltage value from the second electrical signal, and optionally integrate the voltage value to obtain the corresponding magnetic flux.

In one embodiment, the coaxial cable is omitted so that the capacitive air-gap sensor is directly connected to the triaxial cable.

It should be understood that the conditioner may be seen as comprising two conditioner units, a first conditioner unit being adapted to extract the air-gap thickness and a second conditioner unit being adapted to extract the voltage or flux value.

It should be understood that the capacitive air-gap sensor and the coil are each adapted, i.e. sized and shaped, to be positioned in the air-gap between the stator and the rotor poles of the rotating machine.

For cases where expected fluxes are slightly above measured fluxes, and to reduce the occurrence of false alarms, the method characterized by Formula (1) may still be applicable in the following way:

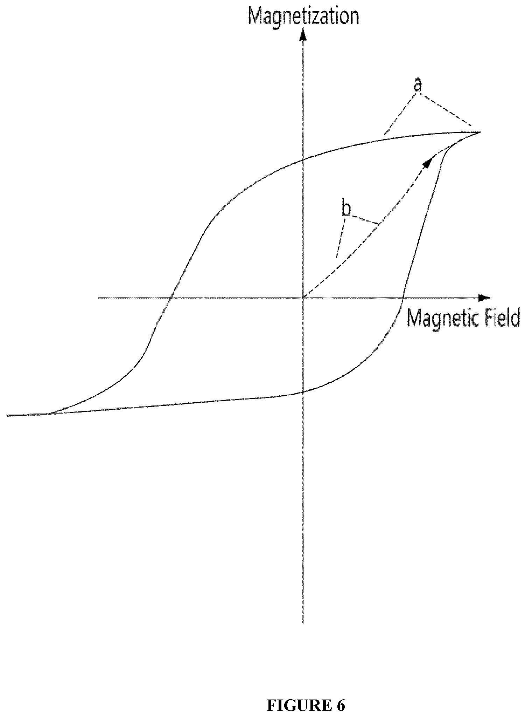

FIG. 6 shows the traditional hysteresis cycle that characterizes the magnetization of a magnetic circuit, and in the present case, of the salient pole core.

As seen on FIG. 6, under normal conditions of operation, magnetization is maximum, situated in the right upper half of the first quadrant (zone a) or in the opposite side depending on the pole polarity, and the magnetization curve is nearly horizontal. This means that even if a shorted turn exists on a given pole, even a substantial decrease of the magnetizing current may not produce a detectable decrease of the flux, and this may explain why a shorted turn, which generally causes a slight decrease of the flux, may not be detected under such normal conditions of operation.

It should be noticed that, for a given variation of the current NI flowing through the pole windings, the variation of the magnetic radial flux Ø is more detectable when a first magnetization occurs (zone b), since for each magnetizing current increase, the slope of increase of the radial flux (ΔØ/ΔNI) is steeper.

It follows that if there exists a shorted turn on a given pole, maximum probability of its detection will happen when the machine operates along zone b, where sensitivity of detection is maximum, because ΔØ/ΔNI will be maximum and also because the machine being the only one to generate a voltage, the contribution of each pole can be observed without having the damping effect of any of the other machines on the grid.

To operate in zone b, the first condition is to reduce the magnetic remanence of the pole core as much as possible. This can be obtained by cutting off the magnetizing current and putting the electric rotating machine off-line. Given the ferro-magnetic nature of the material of the pole core, it should only take a few seconds to reduce the magnetic remanence of the pole core to zero or near zero.

Once this objective is attained, the magnetizing current may be increased step by step and the values of the radial flux and air-gap at each step should be measured in real time. Maximum probability of short turn detection should occur when the machine operates approximately between 1/4 and 2/3 of the maximum magnetic field.

Then the above calculations of the expected fluxes according to Formula (1) may be applied and the shorted turns identified.

## Claims

1. A method for detecting shorted turns in the windings of salient rotor poles of an electric rotating machine, the method comprising:
for each one of the salient rotor poles, measuring a radial magnetic flux between a stator of the electric rotating machine and the salient rotor pole, and measuring a thickness of an air-gap between the stator and the salient rotor pole;
for each one of the salient rotor poles, determining an expected radial flux using the measured radial magnetic flux and the measured thickness of the air-gap; and
identifying shorted turns by comparing, for each one of the salient rotor poles, the measured radial magnetic flux to the expected radial magnetic flux.

2. The method of claim 1, further comprising, for each one of the salient rotor poles, determining a maximum radial magnetic flux from the measured radial flux, and a minimum air-gap thickness from the measured thickness of the air-gap.

3. The method of claim 2, wherein said determining the expected radial flux comprises:
calculating an average value for the minimum air-gap thicknesses and an average value for the maximum radial magnetic fluxes; and
for each one of the salient rotor poles, calculating the expected radial magnetic flux using the respective measured thickness of the air-gap, the average value for the minimum air-gap thicknesses and the average value for the maximum radial magnetic fluxes.

4. The method of claim 3, wherein the shorted turn is determined when a measured radial magnetic flux for a given salient rotor pole is less than the respective expected radial magnetic flux for the given salient rotor pole.

5. The method of claim 1, wherein said measuring the radial magnetic flux and said measuring the thickness of the air-gap are performed substantially concurrently using a magnetic radial flux sensor integrated with an air-gap sensor positioned in the air-gap.

6. The method of claim 1, further comprising:
bringing the electric rotating machine off-line;
bringing a magnetic remanence of the salient rotor poles substantially near zero by shutting off a current flowing through the windings of the salient rotor poles;
reinstating gradually said current up to a nominal value;
for each one of the salient rotor poles, measuring the radial magnetic flux and the thickness of the air-gap;
for each one of the salient rotor poles, determining an expected radial flux using the measured radial magnetic flux and the measured thickness of the air-gap; and
identifying shorted turns by identifying at least a given one of the salient rotor poles having a measured radial magnetic flux inferior to the corresponding expected radial magnetic flux.

7. The method of claim 1, further comprising outputting an identification of a given one of the salient rotor poles for which shorted turns have been detected.

8. A system for detecting shorted turns in windings of salient rotor poles of an electric rotating machine comprising:
a radial magnetic flux sensor for measuring a radial magnetic flux between the stator and the salient rotor pole, for each one of the salient rotor poles;
an air-gap thickness sensor for measuring a thickness of an air-gap between the stator and the salient rotor pole, for each one of the salient rotor poles; and
a calculation unit in communication with the magnetic radial flux sensor and the air-gap thickness sensor, the calculation unit for:
for each one of the salient rotor poles, determining an expected radial flux using the measured radial magnetic flux and the measured thickness of the air-gap; and
identifying shorted turns by comparing, for each one of the salient rotor poles, the measured radial magnetic flux to the expected radial magnetic flux.

9. The system of claim 8, wherein the radial magnetic flux sensor comprises a coil adapted to be positioned in the air-gap of the electric rotating machine.

10. The system of claim 8, wherein the calculation unit is further adapted to, for each one of the salient rotor poles, determine a maximum radial magnetic flux from the measured radial flux, and a minimum air-gap thickness from the measured thickness of the air-gap.

11. The system of claim 10, wherein the calculation unit is further adapted to:
calculate an average value for the minimum air-gap thicknesses and an average value for the maximum radial magnetic fluxes; and
for each one of the salient rotor poles, calculate the expected radial magnetic flux using the respective measured thickness of the air-gap, the average value for the minimum air-gap thicknesses and the average value for the maximum radial magnetic fluxes.

12. The system of claim 11, wherein the calculation unit is further adapted to identify the shorted turn when a measured radial magnetic flux for a given salient rotor pole is less than the respective expected radial magnetic flux for the given salient rotor pole.

13. The system of claim 8, further comprising a control unit for:
bringing the electric rotating machine off-line;
bringing a magnetic remanence of the salient rotor poles substantially near zero by shutting off a current flowing through the windings of the salient rotor poles; and
reinstating gradually the current up to a nominal value,
the measurement of the radial magnetic flux and the thickness of the air-gap, the determination of the expected radial flux, and the identification of the shorted turns being performed after the reinstatement of the current.

14. A computer program product comprising a computer readable memory for storing computer executable instructions thereon for detecting shorted turns in the windings of salient rotor poles of an electric rotating machine, the computer executable instructions for performing, upon execution by a computer, the steps of the method according to any one of claims 1-7.

15. A monitoring system for monitoring an air-gap thickness between a stator of an electric rotating machine and a rotor pole, and a magnetic flux between the stator and the rotor pole, the system comprising:
an air-gap sensor for measuring the air-gap thickness and outputting a first electrical signal indicative of the air-gap thickness;
a magnetic flux sensor for monitoring the magnetic flux and outputting a second electrical signal indicative of the magnetic flux, the second electrical signal having an electrical frequency being less than an electrical frequency of the first electrical signal;
a triaxial cable having a first end connected to the air-gap sensor and to the magnetic flux sensor, and having a substantially low frequency bandwidth for transmitting the second electrical signal and a substantially high frequency bandwidth for transmitting the first electrical signal;
a first capacitor operatively connected between the triaxial cable and the magnetic flux sensor;
a first conditioner unit connected to a second end of the triaxial cable and adapted to receive the first electrical signal, extract the air-gap thickness form the first electrical signal, and output the air-gap thickness; and
a second conditioner unit connected to a second end of the triaxial cable and adapted to receive the second electrical signal, extract a parameter indicative of the magnetic flux form the second electrical signal, and output the parameter; and
a second capacitor operatively connected between the triaxial cable and the second conditioner unit.

16. The monitoring system of claim 15, wherein the magnetic flux sensor comprises a coil and is adapted to measure a voltage generated within the coil, the second electrical signal being indicative of the voltage and the second conditioner unit being adapted to extract the voltage from the second electrical signal.

17. The monitoring system of claim 16, wherein the second conditioner unit is further adapted to determine the magnetic flux between the stator and the rotor pole from the voltage, and output the magnetic flux.

## Patentansprüche

1. Verfahren zum Detektieren von kurzgeschlossenen Windungen in den Wicklungen von ausgeprägten Rotorpolen einer elektrischen rotierenden Maschine, wobei das Verfahren umfasst:
Messen eines radialen Magnetflusses zwischen einem Stator der elektrischen rotierenden Maschine und dem ausgeprägten Rotorpol und Messen einer Dicke eines Luftspalts zwischen dem Stator und dem ausgeprägten Rotorpol für jeden der ausgeprägten Rotorpole;
Ermitteln eines erwarteten radialen Flusses unter Verwendung des gemessenen radialen Magnetflusses und der gemessenen Dicke des Luftspalts für jeden der ausgeprägten Rotorpole; und
Identifizieren von kurzgeschlossenen Windungen durch Vergleichen des gemessenen radialen Magnetflusses mit dem erwarteten radialen Magnetfluss für jeden der ausgeprägten Rotorpole.

2. Verfahren nach Anspruch 1, das ferner das Ermitteln eines maximalen radialen Magnetflusses anhand des gemessenen radialen Flusses und einer Luftspaltmindestdicke anhand der gemessenen Dicke des Luftspalts für jeden der ausgeprägten Rotorpole umfasst.

3. Verfahren nach Anspruch 2, wobei das Ermitteln des erwarteten radialen Flusses umfasst:
Berechnen eines Durchschnittswerts für die Luftspaltmindestdicken und eines Durchschnittswerts für die maximalen radialen Magnetflüsse; und
Berechnen des erwarteten radialen Magnetflusses unter Verwendung der jeweiligen gemessenen Dicke des Luftspalts, des Durchschnittswerts für die Luftspaltmindestdicken und des Durchschnittswerts für die maximalen radialen Magnetflüsse für jeden der ausgeprägten Rotorpole.

4. Verfahren nach Anspruch 3, wobei die kurzgeschlossene Windung ermittelt wird, wenn ein gemessener radialer Magnetfluss für einen bestimmten ausgeprägten Rotorpol kleiner als der jeweilige erwartete radiale Magnetfluss für den bestimmten ausgeprägten Rotorpol ist.

5. Verfahren nach Anspruch 1, wobei das Messen des radialen Magnetflusses und das Messen der Dicke des Luftspalts unter Verwendung eines Radialer-Magnetfluss-Sensors, der mit einem im Luftspalt positionierten Luftspaltsensor kombiniert ist, im Wesentlichen gleichzeitig durchgeführt werden.

6. Verfahren nach Anspruch 1, das ferner umfasst:
Trennen der elektrischen rotierenden Maschine vom Netz;
Bringen einer magnetischen Remanenz der ausgeprägten Rotorpole auf im Wesentlichen nahe null, indem ein durch die Wicklungen der ausgeprägten Pole fließender Strom abgeschaltet wird;
schrittweises Wiedereinsetzen des Stroms bis zu einem Nominalwert;
Messen des radialen Magnetflusses und der Dicke des Luftspalts für jeden der ausgeprägten Rotorpole;
Ermitteln eines erwarteten radialen Flusses unter Verwendung des gemessenen radialen Magnetflusses und der gemessenen Dicke des Luftspalts für jeden der ausgeprägten Rotorpole; und
Identifizieren von kurzgeschlossenen Windungen durch Identifizieren zumindest eines bestimmten der ausgeprägten Rotorpole mit einem gemessenen radialen Magnetfluss, der geringer als der entsprechende erwartete radiale Magnetfluss ist.

7. Verfahren nach Anspruch 1, das ferner das Ausgeben einer Identifikation eines bestimmten der ausgeprägten Rotorpole, in Bezug auf welchen kurzgeschlossene Windungen detektiert wurden, umfasst.

8. System zum Detektieren von kurzgeschlossenen Windungen in Wicklungen von ausgeprägten Rotorpolen einer elektrischen rotierenden Maschine, das umfasst:
einen Radialer-Magnetfluss-Sensor zum Messen eines radialen Magnetflusses zwischen dem Stator und dem ausgeprägten Rotorpol für jeden der ausgeprägten Rotorpole;
einen Luftspaltdickensensor zum Messen einer Dicke eines Luftspalts zwischen dem Stator und dem ausgeprägten Rotorpol für jeden der ausgeprägten Rotorpole; und
eine Berechnungseinheit, die mit dem Radialer-Magnetfluss-Sensor und dem Luftspaltdickensensor in Kommunikation steht, wobei die Berechnungseinheit vorgesehen ist zum:
Ermitteln eines erwarteten radialen Flusses unter Verwendung des gemessenen radialen Magnetflusses und der gemessenen Dicke des Luftspalts für jeden der ausgeprägten Rotorpole; und
Identifizieren von kurzgeschlossenen Windungen durch Vergleichen des gemessenen radialen Magnetflusses mit dem erwarteten radialen Magnetfluss für jeden der ausgeprägten Rotorpole.

9. System nach Anspruch 8, wobei der Radialer-Magnetfluss-Sensor eine Spule umfasst, die so ausgelegt ist, dass sie im Luftspalt der elektrischen rotierenden Maschine positioniert wird.

10. System nach Anspruch 8, wobei die Berechnungseinheit ferner so ausgelegt ist, dass sie einen maximalen radialen Magnetfluss anhand des gemessenen radialen Flusses und eine Luftspaltmindestdicke anhand der gemessenen Dicke des Luftspalts für jeden der ausgeprägten Rotorpole ermittelt.

11. System nach Anspruch 10, wobei die Berechnungseinheit ferner ausgelegt ist zum:
Berechnen eines Durchschnittswerts für die Luftspaltmindestdicken und eines Durchschnittswerts für die maximalen radialen Magnetflüsse; und
Berechnen des erwarteten radialen Magnetflusses unter Verwendung der jeweiligen gemessenen Dicke des Luftspalts, des Durchschnittswerts für die Luftspaltmindestdicken und des Durchschnittswerts für die maximalen radialen Magnetflüsse für jeden der ausgeprägten Rotorpole.

12. System nach Anspruch 11, wobei die Berechnungseinheit ferner so ausgelegt ist, dass sie die kurzgeschlossene Windung identifiziert, wenn ein gemessener radialer Magnetfluss für einen bestimmten ausgeprägten Rotorpol kleiner als der jeweilige erwartete radiale Magnetfluss für den bestimmten ausgeprägten Rotorpol ist.

13. System nach Anspruch 8, das ferner eine Steuereinheit umfasst zum:
Trennen der elektrischen rotierenden Maschine vom Netz;
Bringen einer magnetischen Remanenz der ausgeprägten Rotorpole auf im Wesentlichen nahe null, indem ein durch die Wicklungen der ausgeprägten Pole fließender Strom abgeschaltet wird;
schrittweises Wiedereinsetzen des Stroms bis zu einem Nominalwert,
wobei das Messen des radialen Magnetflusses und der Dicke des Luftspalts, das Ermitteln des erwarteten radialen Flusses und das Identifizieren der kurzgeschlossenen Windungen nach Wiedereinsetzen des Stroms durchgeführt werden.

14. Computerprogrammprodukt, das einen computerlesbaren Speicher zum Speichern von computerausführbaren Anweisungen in diesem zum Detektieren von kurzgeschlossenen Windungen in den Wicklungen von ausgeprägten Rotorpolen einer elektrischen rotierenden Maschine umfasst, wobei die computerausführbaren Anweisungen bei Ausführung durch einen Computer zum Durchführen der Schritte des Verfahrens nach einem der Ansprüche 1 bis 7 vorgesehen sind.

15. Überwachungssystem zum Überwachen einer Luftspaltdicke zwischen einem Stator einer elektrischen rotierenden Maschine und einem Rotorpol und eines Magnetflusses zwischen dem Stator und dem Rotorpol, wobei das System umfasst:
einen Luftspaltsensor zum Messen der Luftspaltdicke und Ausgeben eines ersten elektrischen Signals, das für die Luftspaltdicke indikativ ist;
einen Magnetflusssensor zum Überwachen des Magnetflusses und Ausgeben eines zweiten elektrischen Signals, das für den Magnetfluss indikativ ist, wobei das zweite elektrische Signal eine elektrische Frequenz aufweist, die geringer als eine elektrische Frequenz des ersten elektrischen Signals ist;
ein triaxiales Kabel mit einem ersten Ende, das mit dem Luftspaltsensor und mit dem Magnetflusssensor verbunden ist und das eine im Wesentlichen niederfrequente Bandbreite zum Senden des zweiten elektrischen Signals und eine im Wesentlichen hochfrequente Bandbreite zum Senden des ersten elektrischen Signals aufweist;
einen ersten Kondensator, der zwischen dem triaxialen Kabel und dem Magnetflusssensor operativ verbunden ist;
eine erste Konditionierungseinheit, die mit einem zweiten Ende des triaxialen Kabels verbunden und so ausgelegt ist, dass sie das erste elektrische Signal empfängt, die Luftspaltdicke aus dem ersten elektrischen Signal extrahiert und die Luftspaltdicke ausgibt; und
eine zweite Konditionierungseinheit, die mit einem zweiten Ende des triaxialen Kabels verbunden und so ausgelegt ist, dass sie das zweite elektrische Signal empfängt, einen für den Magnetfluss indikativen Parameter aus dem zweiten elektrischen Signal extrahiert und den Parameter ausgibt; und
einen zweiten Kondensator, der zwischen dem triaxialen Kabel und der zweiten Konditionierungseinheit operativ verbunden ist.

16. Überwachungssystem nach Anspruch 15, wobei der Magnetflusssensor eine Spule umfasst und so ausgelegt ist, dass er eine innerhalb der Spule erzeugte Spannung misst, wobei das zweite elektrische Signal für die Spannung indikativ ist und die zweite Konditionierungseinheit so ausgelegt ist, dass sie die Spannung aus dem zweiten elektrischen Signal extrahiert.

17. Überwachungssystem nach Anspruch 16, wobei die zweite Konditionierungseinheit ferner so ausgelegt ist, dass sie den Magnetfluss zwischen dem Stator und dem Rotorpol anhand der Spannung ermittelt und den Magnetfluss ausgibt.

## Revendications

1. Procédé de détection de spires court-circuitées dans les enroulements de pôles de rotor saillants d'une machine électrique tournante, le procédé comprenant :
pour chacun des pôles de rotor saillants, mesurer un flux magnétique radial entre un stator de la machine électrique tournante et le pôle de rotor saillant, et mesurer une épaisseur d'un entrefer entre le stator et le pôle de rotor saillant ;
pour chacun des pôles de rotor saillants, déterminer un flux radial attendu en utilisant le flux magnétique radial mesuré et l'épaisseur mesurée de l'entrefer ; et
identifier des spires court-circuitées par comparaison, pour chacun des pôles de rotor saillants, du flux magnétique radial mesuré avec le flux magnétique radial attendu.

2. Procédé selon la revendication 1, comprenant en outre, pour chacun des pôles de rotor saillants, déterminer un flux magnétique radial maximal à partir du flux radial mesuré, et une épaisseur d'entrefer minimale à partir de l'épaisseur mesurée de l'entrefer.

3. Procédé selon la revendication 2, dans lequel ladite détermination du flux radial attendu comprend :
calculer une valeur moyenne des épaisseurs d'entrefer minimales et une valeur moyenne des flux magnétiques radiaux maximaux ; et
pour chacun des pôles de rotor saillants, calculer le flux magnétique radial attendu en utilisant l'épaisseur mesurée respective de l'entrefer, la valeur moyenne des épaisseurs d'entrefer minimales et la valeur moyenne des flux magnétiques radiaux maximaux.

4. Procédé selon la revendication 3, dans lequel la spire court-circuitée est déterminée lorsqu'un flux magnétique radial mesuré pour un pôle de rotor saillant donné est inférieur au flux magnétique radial attendu respectif pour le pôle de rotor saillant donné.

5. Procédé selon la revendication 1, dans lequel ladite mesure du flux magnétique radial et ladite mesure de l'épaisseur de l'entrefer sont réalisées sensiblement simultanément en utilisant un capteur de flux radial magnétique intégré à un capteur d'entrefer positionné dans l'entrefer.

6. Procédé selon la revendication 1, comprenant en outre :
amener la machine électrique tournante à être hors-ligne ;
amener une rémanence magnétique des pôles de rotor saillants à être sensiblement proche de zéro en coupant un courant circulant à travers les enroulements des pôles de rotor saillants ;
rétablir progressivement ledit courant jusqu'à une valeur nominale ;
pour chacun des pôles de rotor saillants, mesurer le flux magnétique radial et l'épaisseur de l'entrefer ;
pour chacun des pôles de rotor saillants, déterminer un flux radial attendu en utilisant le flux magnétique radial mesuré et l'épaisseur mesurée de l'entrefer ; et
identifier des spires court-circuitées par identification d'au moins un pôle donné, parmi les pôles de rotor saillants, ayant un flux magnétique radial mesuré inférieur au flux magnétique radial attendu correspondant.

7. Procédé selon la revendication 1, comprenant en outre délivrer en sortie une identification d'un pôle donné, parmi les pôles de rotor saillants, pour lequel des spires court-circuitées ont été détectées.

8. Système pour détecter des spires court-circuitées dans des enroulements de pôles de rotor saillants d'une machine électrique tournante, comprenant :
un capteur de flux magnétique radial pour mesurer un flux magnétique radial entre le stator et le pôle de rotor saillant, pour chacun des pôles de rotor saillants ;
un capteur d'épaisseur d'entrefer pour mesurer une épaisseur d'un entrefer entre le stator et le pôle de rotor saillant, pour chacun des pôles de rotor saillants ; et
une unité de calcul en communication avec le capteur de flux radial magnétique et le capteur d'épaisseur d'entrefer, l'unité de calcul servant à :
pour chacun des pôles de rotor saillants, déterminer un flux radial attendu en utilisant le flux magnétique radial mesuré et l'épaisseur mesurée de l'entrefer ; et
identifier des spires court-circuitées par comparaison, pour chacun des pôles de rotor saillants, du flux magnétique radial mesuré avec le flux magnétique radial attendu.

9. Système selon la revendication 8, dans lequel le capteur de flux magnétique radial comprend une bobine adaptée pour être positionnée dans l'entrefer de la machine électrique tournante.

10. Système selon la revendication 8, dans lequel l'unité de calcul est en outre adaptée, pour chacun des pôles de rotor saillants, pour déterminer un flux magnétique radial maximal à partir du flux radial mesuré, et une épaisseur d'entrefer minimale à partir de l'épaisseur mesurée de l'entrefer.

11. Système selon la revendication 10, dans lequel l'unité de calcul est en outre adaptée pour :
calculer une valeur moyenne des épaisseurs d'entrefer minimales et une valeur moyenne des flux magnétiques radiaux maximaux ; et
pour chacun des pôles de rotor saillants, calculer le flux magnétique radial attendu en utilisant l'épaisseur mesurée respective de l'entrefer, la valeur moyenne des épaisseurs d'entrefer minimales et la valeur moyenne des flux magnétiques radiaux maximaux.

12. Système selon la revendication 11, dans lequel l'unité de calcul est en outre adaptée pour identifier la spire court-circuitée lorsqu'un flux magnétique radial mesuré pour un pôle de rotor saillant donné est inférieur au flux magnétique radial attendu respectif pour le pôle de rotor saillant donné.

13. Système selon la revendication 8, comprenant en outre une unité de commande pour :
amener la machine électrique tournante à être hors-ligne ;
amener une rémanence magnétique des pôles de rotor saillants à être sensiblement proche de zéro en coupant un courant circulant à travers les enroulements des pôles de rotor saillants ; et
rétablir progressivement le courant jusqu'à une valeur nominale ;
la mesure du flux magnétique radial et de l'épaisseur de l'entrefer, la détermination du flux radial attendu, et l'identification des spires court-circuitées étant réalisées après le rétablissement du courant.

14. Produit programme d'ordinateur comprenant une mémoire lisible par ordinateur pour stocker sur celle-ci des instructions exécutables par un ordinateur afin de détecter des spires court-circuitées dans les enroulements de pôles de rotor saillants d'une machine électrique tournante, les instructions exécutables par ordinateur étant destinées à réaliser, lors d'une exécution par un ordinateur, les étapes du procédé selon l'une quelconque des revendications 1 à 7.

15. Système de surveillance pour surveiller une épaisseur d'entrefer entre un stator d'une machine électrique tournante et un pôle de rotor, et un flux magnétique entre le stator et le pôle de rotor, le système comprenant :
un capteur d'entrefer pour mesurer l'épaisseur d'entrefer et délivrer en sortie un premier signal électrique indiquant l'épaisseur d'entrefer ;
un capteur de flux magnétique pour surveiller le flux magnétique et délivrer en sortie un second signal électrique indiquant le flux magnétique, le second signal électrique ayant une fréquence électrique inférieure à une fréquence électrique du premier signal électrique ;
un câble triaxial ayant une première extrémité reliée au capteur d'entrefer et au capteur de flux magnétique, et ayant une largeur de bande sensiblement à basse fréquence pour transmettre le second signal électrique et une largeur de bande sensiblement à haute fréquence pour transmettre le premier signal électrique ;
un premier condensateur relié de manière fonctionnelle entre le câble triaxial et le capteur de flux magnétique ;
une première unité conditionneur reliée à une seconde extrémité du câble triaxial et adaptée pour recevoir le premier signal électrique, extraire l'épaisseur d'entrefer à partir du premier signal électrique, et délivrer en sortie l'épaisseur d'entrefer ; et
une seconde unité conditionneur reliée à une seconde extrémité du câble triaxial et adaptée pour recevoir le second signal électrique, extraire un paramètre indiquant le flux magnétique à partir du second signal électrique, et délivrer en sortie le paramètre ; et
un second condensateur relié de manière fonctionnelle entre le câble triaxial et la seconde unité conditionneur.

16. Système de surveillance selon la revendication 15, dans lequel le capteur de flux magnétique comprend une bobine et est adapté pour mesurer une tension générée à l'intérieur de la bobine, le second signal électrique indiquant la tension et la seconde unité conditionneur étant adaptée pour extraire la tension à partir du second signal électrique.

17. Système de surveillance selon la revendication 16, dans lequel la seconde unité conditionneur est en outre adaptée pour déterminer le flux magnétique entre le stator et le pôle de rotor à partir de la tension, et délivrer en sortie le flux magnétique.
